(19) Europäisches Patentamt
European Patent Office
Office européen des brevets

(11) EP 4 775 700 A1

(12) # EUROPEAN PATENT APPLICATION
published in accordance with Art. 153(4) EPC

(43) Date of publication:
**15.07.2026 Bulletin 2026/29**

(21) Application number: **24862798.6**

(22) Date of filing: **03.09.2024**

(51) International Patent Classification (IPC):
***C22C 5/06*** (2006.01) ***B22F 1/00*** (2022.01)
***B22F 1/05*** (2022.01) ***B22F 1/10*** (2022.01)
***C22C 9/00*** (2006.01) ***C22C 27/04*** (2006.01)
***C22C 27/06*** (2006.01) ***C22C 28/00*** (2006.01)
***H01B 1/00*** (2006.01) ***H01B 1/02*** (2006.01)
***H01B 1/22*** (2006.01) ***H05K 1/03*** (2006.01)
***H05K 3/12*** (2006.01)

(52) Cooperative Patent Classification (CPC):
**B22F 1/00; B22F 1/05; B22F 1/10; C22C 5/06; C22C 9/00; C22C 27/04; C22C 27/06; C22C 28/00; H01B 1/00; H01B 1/02; H01B 1/22; H05K 1/03; H05K 3/12**

(86) International application number:
**PCT/JP2024/031632**

(87) International publication number:
**WO 2025/053146 (13.03.2025 Gazette 2025/11)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **08.09.2023 JP 2023146497**

(71) Applicants:
- **Daicel Corporation**
  **Osaka-shi, Osaka 530-0011 (JP)**
- **The University of Osaka**
  **Osaka 565-0871 (JP)**

(72) Inventors:
- **UESHIMA, Minoru**
  **Tokyo 108-8230 (JP)**
- **NAKAYAMA, Koji**
  **Suita-shi, Osaka 565-0871 (JP)**

(74) Representative: **Grünecker Patent- und Rechtsanwälte**
**PartG mbB**
**Leopoldstraße 4**
**80802 München (DE)**

(54) **ALLOY, PARTICLES, ALLOY RIBBON, PREFORM, SINTERED BODY, JOINED BODY, ELECTRONIC DEVICE, AND SINTERED BODY PRODUCTION METHOD**

(57) An alloy that can easily form a sintered body having excellent bonding reliability is provided. The alloy of the present disclosure contains a solid solution phase of a metal element Y in a metal element X, and the metal element X is deposited on a surface by heat treatment in a gas phase, liquid phase, or solid phase atmosphere forming a compound with the metal element Y. The metal element X is preferably deposited on the surface by the heat treatment in an oxygen atmosphere. The metal element X is preferably Ag and/or Cu. Preferably, the metal element X contains Ag and the metal element Y contains Si and/or Ge.

EP 4 775 700 A1

## Description

### Technical Field

The present disclosure relates to an alloy, particles, an alloy ribbon, a preform, a sintered body, a bonding body, an electronic device, and a sintered body production method. The present application claims priority to JP 2023-146497 filed in Japan on September 8, 2023, the content of which is incorporated herein by reference.

### Background Art

A semiconductor used for a power device is required to have high efficiency, low loss, and high-frequency switching, and use of SiC and GaN semiconductors, which are wide-gap semiconductors, has been expanding. In such a semiconductor, operating temperature may exceed 200°C, and a bonding material used for bonding is required to maintain high bonding reliability even during operation of the semiconductor at a high temperature range or operation in an extreme temperature cycling environment.

In recent years, use of silver (Ag) paste having high electric conductivity and thermal conductivity, a high melting point, and stability has been gathering attention. However, due to the high melting point of Ag, when bulk bonding is attempted, a substrate is thermally damaged. Thus, to reduce bonding temperature, low temperature sintering techniques using nano particles have been employed.

As a material having high bonding reliability even during operation at such a high temperature range or operation in such an extreme temperature cycling environment, for example, a metallic sintered bonding body of Patent Document 1 has been known.

### Citation List

### Patent Document

Patent Document 1: WO 2018/037992

### Summary of Invention

### Technical Problem

However, the metallic sintered bonding body of Patent Document 1 had a limitation, by which sintering is required to be performed under a certain pressure and a certain heating condition for exhibition of high bonding reliability, and furthermore, there is room for improvement in bonding reliability of the resulting sintered body.

Furthermore, in the case of typical metal nanoparticles, the sintering temperature can be reduced as the particle size decreases, but, at the same time, the porosity increases, and thus a problem has been known in that cracks are easily caused due to repeated heating. Thus, to exhibit satisfactory bonding reliability after bonding, setting of detailed conditions of composition and/or heat treatment of the metallic sintered bonding body is required.

The present disclosure is to solve the problems described above and provides an alloy that can easily form a sintered body having excellent bonding reliability.

### Solution to Problem

As a result of diligent effort to solve the problems described above, the inventor of the present disclosure found that a sintered body having excellent bonding reliability can be easily formed by an alloy which contains a solid solution phase of a metal element Y in a metal element X and in which the metal element X is deposited on a surface by a specific treatment.

That is, the present disclosure provides an alloy including a solid solution phase of a metal element Y in a metal element X, the metal element X being deposited on a surface by heat treatment in a gas phase, liquid phase, or solid phase atmosphere forming a compound with the metal element Y.

In the alloy, by the heat treatment in an gas phase, liquid phase, or solid phase atmosphere forming a compound with the metal element Y, the metal element X is deposited on the alloy surface while the metal element Y forms a compound. The deposited metal element X can firmly bond with the surrounding alloy, and thus excellent bonding reliability is achieved.

Preferably, by the heat treatment in an oxygen atmosphere, the metal element X is deposited on the alloy surface while the metal element Y is oxidized, in the alloy.

In the alloy, the metal element X is preferably Ag and/or Cu. With the configuration described above, operation at high temperatures is facilitated.

In the alloy, the metal element X is preferably Ag and the metal element Y is preferably Si and/or Ge. With the above configuration, the metal element X and the metal element Y are less likely to form a compound and likely to include the solid solution phase.

In the alloy, the metal element X is preferably Cu and the metal element Y is preferably W and/or Cr. With the above configuration, the metal element X and the metal element Y are less likely to form a compound and likely to include the solid solution phase.

The alloy preferably contains the metal element Y as a supersaturated solid solution in the metal element X. With the above configuration, the metal element X is readily deposited on the alloy surface at the heat treatment.

In the alloy, the molar ratio of the metal element X to the metal element Y [metal element X/metal element Y] is preferably from 95/5 to 10/90. With the above configuration, the solid solution phase of the metal element Y in the metal element X is likely to be contained.

Furthermore, the present disclosure provides particles containing the alloy.

The average particle size of the particles is preferably from 0.1 to 100 μm.

Furthermore, the present disclosure provides an alloy ribbon containing the alloy.

Furthermore, the present disclosure provides a paste containing the particles, an organic substance, and an Ag powder and/or a Cu powder.

Furthermore, the present disclosure provides a preform containing the alloy.

The preform is preferably in a sheet shape or a spherical shape.

Furthermore, the present disclosure provides a sintered body of the alloy.

Furthermore, the present disclosure provides a bonding body containing the sintered body.

Furthermore, the present disclosure provides a substrate containing the bonding body.

Furthermore, the present disclosure provides an electronic device containing the bonding body.

Furthermore, the present disclosure provides a method for producing a sintered body, the method including performing a heat treatment in a gas phase, liquid phase, or solid phase atmosphere forming a compound with the metal element Y.

Furthermore, the present disclosure provides a method for producing a sintered body, the method including performing a heat treatment of the alloy in an oxygen atmosphere.

In the above method for producing a sintered body, the oxygen concentration at the time of the heat treatment is preferably from 0.01 to 30%.

## Advantageous Effects of Invention

The alloy of the present disclosure can easily provide a sintered body having excellent bonding reliability. Thus, an electronic device using the alloy of the present disclosure has excellent bonding reliability.

## Brief Description of Drawings

FIG. 1 is an SEM image of a sintered body of the present disclosure.
FIG. 2 is a cross-sectional view illustrating an electronic device according to an embodiment of the present disclosure.

## Description of Embodiments

### Alloy

An alloy of an embodiment of the present disclosure contains a solid solution phase of a metal element Y in a metal element X, and the metal element X is deposited on a surface by heat treatment in a gas phase, liquid phase, or solid phase atmosphere forming a compound with the metal element Y. In the alloy, by the heat treatment in an gas phase, liquid phase, or solid phase atmosphere forming a compound with the metal element Y, the metal element X is deposited on the alloy surface while the metal element Y in the solid solution phase forms a compound. The deposited metal element X can be firmly bonded to the surrounding alloy and/or a member to be bonded, and thus excellent bonding reliability can be achieved. Furthermore, because the metal element X bonds while being deposited, a specific pressurizing condition or the like is not required, and the bonding can be performed easily. As each of the metal element X and the metal element Y in the alloy, one type may be used alone or a combination of two or more types may be used.

Examples of the element contained in the gas phase, liquid phase, or solid phase forming a compound with the

metal element Y preferably include oxygen and sulfur and, in particular, include sulfur dioxide and hydrogen sulfide. That is, in the alloy, the metal element X is preferably deposited on the alloy surface while the metal element Y is oxidized by the heat treatment in an oxygen atmosphere.

The alloy preferably contains a eutectic of the metal element X and the metal element Y. By setting the alloy to contain the eutectic, the solid solution phase of the metal element Y in the metal element X is likely to be contained.

Furthermore, the alloy preferably has the solid solution phase on the alloy surface. Specifically, the proportion of the solid solution phase in the entire alloy surface described above (100%) is preferably 10% or more, more preferably 15% or more, and even more preferably 20% or more. By setting the proportion of the solid solution phase in the alloy surface to be 10% or more, the metal element X can be sufficiently deposited on the surface when sintering is performed.

Furthermore, the proportion of the solid solution phase is preferably 3 mass% or more, more preferably 5 mass% or more, and even more preferably 10 mass% or more, with respect to 100 mass% of the total amount of the alloy. By setting the proportion of the solid solution phase to be 3 mass% or more, the metal element X can be sufficiently deposited on the surface when sintering is performed.

Note that, in the present disclosure, the term "metal element" also encompasses metalloid elements. Examples of the metalloid elements include Si and Ge.

As the metal element X, Ag and/or Cu is preferably contained. Because Ag and Cu have high melting points, when Ag and Cu are used as the metal element X, the melting point of the alloy can be made high, and thus operation at high temperatures is facilitated.

Specific examples of the metal element Y include Si, Ge, W, and Cr. In particular, in the case where the metal element X contains Ag, the metal element Y preferably contains Si and/or Ge. In the case where the metal element Y contains Cu, the metal element Y preferably contains W and/or Cr. With the configuration described above, the metal element X and the metal element Y are less likely to form a compound and the formation of the solid solution phase can be facilitated.

Furthermore, the alloy preferably contains the metal element Y as a supersaturated solid solution in the metal element X. With the above configuration, the metal element X is readily deposited on the alloy surface when the heat treatment is performed in an oxygen atmosphere. Note that, in the present disclosure, the supersaturated solid solution can be produced by rapidly cooling a melt of the metal element X and the metal element Y, and thus allowing the metal element Y to be dissolved in the metal element X as a solid solution in a larger amount than usual and in a stable manner. In the supersaturated solid solution, preferably 0.5 mol or more, more preferably 1 mol or more, and even more preferably 1.5 mol or more of the metal element Y is dissolved in 100 mol of the metal element X as a solid solution.

The molar ratio of the metal element X to the metal element Y [metal element X/metal element Y] is preferably from 95/5 to 10/90, more preferably from 93/7 to 30/70, even more preferably from 90/10 to 50/50, and particularly preferably from 90/10 to 70/30. By setting the molar ratio to 95/5 to 10/90, it is possible to facilitate inclusion of the solid solution phase of the metal element Y in the metal element X . Furthermore, even when the proportion of the metal element Y is large, it is possible to facilitate the inclusion of the solid solution phase of the metal element Y in the metal element X.

The content of the metal element X is preferably from 1 to 99 mass%, more preferably from 10 to 98 mass%, and even more preferably from 50 to 97 mass%, with respect to 100 mass% of the alloy. When the content of the metal element X is 1 mass% or more, it is possible to facilitate the inclusion of the solid solution phase of the metal element Y in the metal element X. Furthermore, when the content is 99 mass% or less, exhibition of bonding reliability can be facilitated.

The content of the metal element Y is preferably from 1 to 99 mass%, more preferably from 2 to 90 mass%, and even more preferably from 3 to 50 mass%, with respect to 100 mass% of the alloy. When the content of the metal element Y is 1 mass% or more, exhibition of bonding reliability can be facilitated. When the content is 99 mass% or less, it is possible to facilitate the inclusion of the solid solution phase of the metal element Y in the metal element X.

Furthermore, the total content of the metal element X and the metal element Y is preferably 90 mass% or more, more preferably 95 mass% or more, and even more preferably 100 mass%, in 100 mass% of the total amount of the alloy.

Furthermore, the alloy may contain an additional component besides the metal element X and the metal element Y; and however, from the perspective of ensuring bonding reliability, the additional component is preferably not contained. Examples of the additional component include an element that readily forms a compound with the metal element X or the metal element Y, and a compound containing the element. When the alloy contains the additional component, the content thereof is preferably 10 mass% or less, more preferably 5 mass% or less, and even more preferably 1 mass% or less, with respect to 100 mass% of the total amount of the alloy.

The method for producing the alloy is not particularly limited. The alloy is preferably produced by rapidly cooling a melt of the metal element X and the metal element Y. Furthermore, examples of the rapid cooling method include a water atomization method, a gas atomization method, and a single-roll method.

The forms of the metal element X and the metal element Y to be melted are not particularly limited; and however, because of ease in melting, powder forms are preferred. Particularly from the perspective of efficiently melting, as the forms of the metal element X and the metal element Y, use of a eutectic powder of the metal element X and the metal element Y is preferred.

Particles

As an embodiment of the present disclosure, there are provided particles containing the alloy.

The average particle size (median diameter) of the particles is preferably from 0.1 to 100 μm, more preferably from 0.3 to 50 μm, even more preferably from 0.5 to 30 μm, and particularly preferably from 1.0 to 10 μm. By setting the average particle size to be 0.1 μm or more, handling is facilitated. By setting the average particle size to be 100 μm or less, the surface area of the particles becomes sufficient, and the bonding in a short time period is facilitated. Note that the average particle size (median diameter) can be measured by a laser diffraction/scattering method.

Furthermore, the shape of the particles is not particularly limited. Examples thereof include spherical, flake-like (flat shape), and polyhedric shapes.

The method for producing the particles is not particularly limited. For example, the production can be performed by a method in which a heated melt of the metal element X and the metal element Y is subjected to particle size reduction by a gas atomization method or a water atomization method.

Alloy Ribbon

As an embodiment of the present disclosure, there can be provided an alloy ribbon containing the alloy.

The thickness of the alloy ribbon is preferably from 1 μm to 2 mm, more preferably from 10 μm to 1 mm, and even more preferably from 50 μm to 0.5 mm. When the thickness is 1 μm or more, formation of a ribbon shape is facilitated. When the thickness is 2 mm or less, rapid cooling is facilitated.

The width of the ribbon is preferably from 0.1 to 100 mm, more preferably from 0.5 to 50 mm, and even more preferably from 1 mm to 10 mm. When the width is 0.1 mm or more, formation of a ribbon shape is facilitated. When the width is 100 mm or less, rapid cooling is facilitated.

The method for producing the alloy ribbon is not particularly limited. For example, the production can be performed by a method in which a heated melt of the metal element X and the metal element Y is subjected to rapid cooling by a single-roll method.

Furthermore, as an embodiment of the present disclosure, there is provided a particle-containing composition containing the particles. The particle-containing composition is not particularly limited and may be in various forms. For example, a particle-containing composition, which is called an alloy ink, can be prepared by dispersing the particles in an appropriate organic solvent (dispersion medium) in a suspended state. Alternatively, a particle-containing composition, which is called a paste, can be prepared by dispersing the particles in an organic solvent in a kneaded state. Among these, the particle-containing composition is preferably a paste. As the particles contained in the particle-containing composition, only one type may be used alone or a combination of two or more types may be used.

Paste

The paste preferably contains an organic substance in addition to the particles.

Examples of the organic substance include a reducing organic substance, a basic compound, a coordinating organic compound other than a compound corresponding to the basic compound, a resin, and an organic solvent. One type of the organic substances may be used alone, or two or more types thereof may be used in combination.

Reducing Organic Substance

Examples of the reducing organic substance include alcohols other than those exemplified as the organic solvent described below (lower alcohols such as ethanol and higher alcohols such as palmitoyl), aldehydes (formaldehyde, acetaldehyde, and cyclic trimers and tetramers of these aldehydes), amino acids, organic acids (such as carboxylic acids), and aromatic compounds (such as polyphenol and phenolic acidic compounds). Among them, organic acids (such as carboxylic acids) and aromatic compounds are preferable from the viewpoint of their acidity, and the carboxylic acids are more preferable from the viewpoint of ease of handling at normal temperature and low toxicity. One type of these may be used alone, or two or more types thereof may be used.

Examples of the carboxylic acids include formic acid, acetic acid, lactic acid, propionic acid, acrylic acid, malic acid, n-hexanoic acid, succinic acid, n-octanoic acid, tartaric acid, and oxalic acid, and particularly, formic acid and oxalic acid are preferable from the viewpoint that a sintered body having excellent reducing properties and excellent conductivity is easily obtained.

The reducing organic substance preferably contains formic acid from the viewpoint of excellent reducing properties and superior suppression of voids. **In** addition, the reducing organic substance preferably contains formic acid and a compound having a boiling point higher than that of formic acid (in particular, a compound having a boiling point higher than that of the coordinating organic compound) from the viewpoint that reducing properties is exhibited in a wide

temperature zone.

When formic acid is contained as the reducing organic substance, the content proportion of formic acid is preferably 50 mass% or more, more preferably 60 mass% or more, and still more preferably 80 mass% or more, with respect to the total amount (100 mass%) of the reducing organic substance. When an additional reducing organic substance other than formic acid (for example, a compound having a boiling point higher than that of formic acid) is contained together with formic acid, the content of the additional reducing organic substance is preferably 0.1 parts by mol or less, and more preferably 0.05 parts by mol or less, with respect to 1 part by mol of formic acid.

The content proportion of the reducing organic substance is preferably 5 mass% or less (for example, from 0.1 to 5 mass%), more preferably from 0.1 to 4.0 mass%, still more preferably from 0.2 to 3.7 mass%, and particularly preferably from 0.3 to 3.5 mass%, with respect to the total amount (100 mass%) of the paste.

Basic Compound

The basic compound is not particularly limited as long as it functions as a base and realizes the effects of the present disclosure, and specific examples thereof include nitrogen-containing compounds such as ammonia, amine compounds, and phosphorus-containing compounds such as phosphine and phosphates. Among these, a nitrogen-containing compound represented by Formula (1) below is preferable in that a sintered body having excellent electrical conductivity is easily obtained.

[Chem. 1]

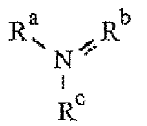

(1)

In Formula (1), $R^a$ to $R^c$ are the same or different, and each represent a hydrogen atom or a hydrocarbon group optionally having a substituent, and the substituent is the same or different, and is at least one group selected from the group consisting of an amino group, an N-substituted amino group, an N,N-substituted amino group, an imino group, an N-substituted imino group, and a hydroxy group, with proviso that $R^a$ to $R^c$ are not hydrogen atoms at the same time; A double line including a broken line represents a single bond or a double bond, and when the double bond is represented, $R^c$ is absent. Any two of $R^a$ to $R^c$ may bond to each other and form a ring together with the adjacent nitrogen atom.

Examples of the hydrocarbon group related to $R^a$ to $R^c$ include an aliphatic hydrocarbon group, an alicyclic hydrocarbon group, and an aromatic hydrocarbon group, and among them, an aliphatic hydrocarbon group and an alicyclic hydrocarbon group are preferable, and an aliphatic hydrocarbon group is more preferable.

Examples of the aliphatic hydrocarbon group include a linear or branched alkyl group, a linear or branched alkenyl group, a linear or branched alkynyl group, and a linear or branched alkylidene group, and among them, a linear or branched alkyl group is preferable.

The linear or branched alkyl group is a linear alkyl group having preferably from 1 to 20 carbon atoms, and more preferably from 1 to 15 carbon atoms, or a branched alkyl group having preferably from 3 to 12 carbon atoms, more preferably from 3 to 8 carbon atoms, and even more preferably from 3 to 6 carbon atoms. Examples of the linear or branched alkyl group include a methyl group, an ethyl group, a propyl group, a butyl group, a pentyl group, a hexyl group, a decyl group, a dodecyl group, a tetradecyl group, an octadecyl group, an isopropyl group, an isobutyl group, a sec-butyl group, a tert-butyl group, and a 2-ethylhexyl group.

The linear or branched alkenyl group is a linear alkenyl group having preferably from 2 to 12 carbon atoms, more preferably from 2 to 8 carbon atoms, and even more preferably from 2 to 4 carbon atoms, or a branched alkenyl group having preferably from 3 to 12 carbon atoms, more preferably from 3 to 8 carbon atoms, and even more preferably from 3 to 6 carbon atoms. Examples of the linear or branched alkenyl group include a vinyl group, a 1-propenyl group, a 2-propenyl group, a 1-butenyl group, a 2-butenyl group, a 3-butenyl group, a 1-pentenyl group, a 2-pentenyl group, a 3-pentenyl group, a 4-pentenyl group, a 1-hexenyl group, a 3-hexenyl group, a 5-hexenyl group, a 1-heptenyl group, a 1-octenyl group, a 1-nonenyl group, a 1-decenyl group, an isopropenyl group, a 2-methyl-1-propenyl group, a methallyl group, a 3-methyl-2-butenyl group, and a 4-methyl-3-pentenyl group.

The linear or branched alkynyl group is a linear alkynyl group having preferably from 2 to 12 carbon atoms, more preferably from 2 to 8 carbon atoms, and even more preferably from 2 to 4 carbon atoms, or a branched alkynyl group having preferably from 3 to 12 carbon atoms, more preferably from 3 to 8 carbon atoms, and even more preferably from 3 to 6 carbon atoms. Examples of the linear or branched alkynyl group include an ethynyl group, a 1-propynyl group, a 2-propynyl group, a 1-butynyl group, a 2-butynyl group, a 3-butynyl group, a 1-pentynyl group, a 2-pentynyl group, a 3-pentynyl group, a 4-pentynyl group, a 1-hexynyl group, a 2-hexynyl group, a 3-hexynyl group, a 4-hexynyl group, a 5-hexynyl group, a 1-heptynyl group, a 1-octynyl group, a 1-nonynyl group, a 1-decynyl group, a trimethylsilylethynyl group, and a triethylsilylethynyl group.

The linear or branched alkylidene group is a linear alkylidene group having preferably from 1 to 12 carbon atoms, more preferably from 1 to 8 carbon atoms, and even more preferably from 2 to 4 carbon atoms, or a branched alkylidene group having preferably from 3 to 12 carbon atoms, more preferably from 3 to 8 carbon atoms, and even more preferably from 3 to 6 carbon atoms. Examples of the linear or branched alkylidene group include a methylidene group, a propylidene group, an isopropylidene group, a butylidene group, an isobutylidene group, a sec-butylidene group, a pentylidene group, an isopentylidene group, an octylidene group, and an isooctylidene group.

Examples of the alicyclic hydrocarbon group include a cycloalkyl group and a cycloalkenyl group.

The cycloalkyl group is a cycloalkyl group having preferably from 3 to 12 carbon atoms, more preferably from 4 to 10 carbon atoms, and even more preferably from 5 to 8 carbon atoms. Examples of the cycloalkyl group include a cyclopropyl group, a cyclobutyl group, a cyclopentyl group, a cyclohexyl group, a cycloheptyl group, a cyclooctyl group, a cyclononyl group, and a cyclodecyl group.

The cycloalkenyl group is a cycloalkenyl group having preferably from 3 to 12 carbon atoms, more preferably from 4 to 10 carbon atoms, and even more preferably from 5 to 8 carbon atoms. Examples of the cycloalkenyl group include a cyclopentenyl group and a cyclohexenyl group.

The aromatic hydrocarbon group is an aryl group having preferably from 6 to 18 carbon atoms, more preferably from 6 to 14 carbon atoms, and even more preferably from 6 to 10 carbon atoms. Examples of the aromatic hydrocarbon group include a phenyl group and a naphthyl group.

The double line including the broken line in Formula (1) represents a single bond or a double bond. When the double line including the broken line is a double bond, $R^c$ is not present, and the nitrogen atom to which $R^a$ and $R^b$ are bonded in Formula (1) represents an imino group or an N-substituted imino group.

The total number of the amino group, the N-substituted amino group, and the N,N-substituted amino group that may be included in $R^a$ to $R^c$ is preferably from 0 to 6, more preferably from 1 to 4, and still more preferably from 1 to 2.

The total number of the imino group and the N-substituted imino group that may be included in $R^a$ to $R^c$ is preferably from 0 to 4, more preferably from 1 to 3, and still more preferably from 1 to 2.

The total number of the hydroxy group that may be included in $R^a$ to $R^c$ is preferably from 0 to 6, more preferably from 1 to 4, and still more preferably from 1 to 2.

A substituent included in the N-substituted amino group, the N,N-substituted amino group, and the N-substituted imino group is the same as the hydrocarbon group related to $R^a$ to $R^c$ described above.

Any two of $R^a$ to $R^c$ may bond to each other and form a ring together with the adjacent nitrogen atom. Examples of the ring to be formed include a pyrrolidine ring, a pyrroline ring, a piperidine ring, a pyrrole ring, an imidazolidine ring, an imidazole ring, a piperazine ring, an imidazolidine ring, a pyridine ring, a diazine ring, and a triazine ring.

The hydrocarbon group related to $R^a$ to $R^c$ may have a substituent other than the amino group, the N-substituted amino group, the N,N-substituted amino group, the imino group, the N-substituted imino group, or the hydroxy group. Examples of such a substituent include halogen atoms (a fluorine atom, a chlorine atom, a bromine atom, and an iodine atom), an oxo group, substituted oxy groups (such as an alkoxy group having from 1 to 4 carbon atoms, an aryl group having from 6 to 10 carbon atoms, an aryloxy group having from 6 to 10 carbon atoms, an aralkyloxy group having from 7 to 16 carbon atoms, and an acyloxy group having from 1 to 4 carbon atoms), a carboxyl group, substituted oxycarbonyl groups (such as an alkoxycarbonyl group having from 1 to 4 carbon atoms, an aryloxycarbonyl group having from 6 to 10 carbon atoms, and an aralkyloxycarbonyl group having from 7 to 16 carbon atoms), a cyano group, a nitro group, a sulfo group, a mercapto group, and a heterocyclic group.

Specific examples of the basic compound represented by Formula (1) include alkylamines in which at least one of $R^a$ to $R^c$ in Formula (1) is a linear or branched alkyl group; monoalkanolamines in which $R^a$ and $R^b$ in Formula (1) are independently a hydrogen atom or a linear or branched alkyl group, and $R^c$ is a linear or branched alkyl group having one hydroxy group; dialkanolamines in which in Formula (1), $R^a$ is a hydrogen atom or a linear or branched alkyl group, and $R^b$ and $R^c$ are, the same or different, and represent a linear or branched alkyl group having one hydroxy group; trialkanolamines in which $R^a$ to $R^c$ in Formula (1) are the same or different, and represent a linear or branched alkyl group having one hydroxy group; aminoalkanediols in which in Formula (1), $R^a$ and $R^b$ are the same or different, and represent a hydrogen atom or a linear or branched alkyl group, and $R^c$ is a linear or branched alkyl group having two hydroxy groups; diamines in which $R^a$ to $R^c$ in Formula (1) have one amino group in total; triamines in which $R^a$ to $R^c$ in Formula (1) have two amino groups in total; diaminoalkanols in which $R^a$ to $R^c$ in Formula (1) have one amino group in total and one hydroxy group in total; imidazole compounds in which $R^a$ to $R^c$ in Formula (1) contain one imino group in total, and a ring is formed containing a nitrogen atom of the imino group; and nitrogen-containing aromatic compounds (such as pyridine-based compounds, diazine-based compounds, and triazine-based compounds) in which the nitrogen atom to which $R^a$ and $R^b$ in Formula (1) are bonded is an imino group, and a ring is formed containing the imino group.

Examples of the alkylamines include methylamine, ethylamine, propylamine, butylamine, pentylamine, dimethylamine, diethylamine, dipropylamine, dibutylamine, dipentylamine, piperidine, trimethylamine, triethylamine, dimethyldecylamine, dimethyldodecylamine, 4-dimethylaminopyridine, 2-aminopyrazine, 2-aminopyrimidine, 3-aminopyridazine, 2-aminotriazine, diazabicyclononene, and diazabicycloundecene.

Examples of the monoalkanolamines include 2-aminoethanol, 3-aminopropanol, 1-amino-2-propanol, 1-amino-2-methyl-2-propanol, 2-amino-2-methyl-1-propanol, 4-amino-1-butanol, 6-amino-1-hexanol, 10-amino-1-decanol, 12-amino-1-dodecanol, N-methyl-2-aminoethanol, N-ethyl-2-aminoethanol, N-propyl-2-aminoethanol, 2-dimethylaminoethanol, 6-diethylaminohexanol, 1-(2-hydroxyethyl) pyrrolidine, 2-(hydroxymethyl) pyrrolidine, 2-(2-hydroxyethyl)-1-methylpyrrolidine, 1-piperidineethanol, and 1-ethanol-4-propanolpiperidine.

Examples of the dialkanolamines include diethanolamine, di-n-propanolamine, diisopropanolamine, di-n-butanolamine, diisobutanolamine, and N-methyldiethanolamine.

Examples of the trialkanolamines include triethanolamine, tri-n-propanolamine, triisopropanolamine, tri-n-butanolamine, and triisobutanolamine.

Examples of the aminoalkanediols include 1-amino-2,3-propanediol, 4-amino-1,2-butanediol, 4-amino-1,3-butanediol, 2-amino-1,3-propanediol, 2-amino-2-methyl-1,3-propanediol, 1-methylamino-2,3-propanediol, 1-ethylamino-2,3-propanediol, 1-propylamino-2,3-propanediol, 1-butylamino-2,3-propanediol, 3-dimethylamino-1,2-propanediol, and 2-diethylamino-1,3-propanediol.

Examples of the diamines include 1,3-propanediamine, 2,2-dimethyl-1,3-propanediamine, 1,4-butanediamine, 1,5-pentanediamine, 1,6-hexanediamine, 1,7-heptanediamine, 1,8-octanediamine, 1,5-diamino-2-methylpentane, N,N'-dimethylethylenediamine, N,N'-diethylethylenediamine, N,N'-dimethyl-1,3-propanediamine, N,N'-diethyl-1,3-propanediamine, N,N'-dimethyl-1,4-butanediamine, N,N'-diethyl-1,4-butanediamine, N,N'-dimethyl-1,6-hexanediamine, N,N-dimethylethylenediamine, N,N-diethylethylenediamine, N,N-dimethyl-1,3-propanediamine, N,N-diethyl-1,3-propanediamine, N,N-dimethyl-1,4-butanediamine, N,N-diethyl-1,4-butanediamine, N,N-dimethyl-1,6-hexanediamine, 1,2-cyclohexanediamine, 1,4-cyclohexanediamine, piperazine, N-methylpiperazine, N-ethylpiperazine, N,N'-dimethylpiperazine, and homopiperazine.

Examples of the triamines include diethylenetriamine, N,N,N',N",N"-pentamethyldiethylenetriamine, N,N,N',N",N"-pentakis(2-hydroxypropyl)diethylenetriamine, 3,3'-diaminodipropylamine, N-(3-aminopropyl)-N-methyl-1,3-propanediamine, N'-[3-(dimethylamino)propyl]-N,N-dimethyl-1,3-propanediamine, 2,6,10-trimethyl-2,6,10-triazaundecane, N-(2-aminoethyl)piperazine, 1,4,7-triazacyclononane, N,N,N',N",N"-pentakis(2-hydroxypropyl)diethylenetriamine, 1-(2-aminoethyl)-4-methylpiperazine, and 1-(2-dimethylaminoethyl)-4-methylpiperazine.

Examples of the diaminoalkanols include 1,3-diaminopropan-2-ol, 2-(2-aminoethylamino)ethanol, 2-(2-aminopropylamino)ethanol, 2-(2-aminoethylmethylamino)ethanol, 1-(2-hydroxyethyl)piperazine, 4-methylpiperazine-1-ethanol, and 1,4-bis(2-hydroxyethyl)piperazine.

Examples of the imidazole compounds include imidazole, 2-methylimidazole, 2-propylimidazole, N-methylimidazole, N-propylimidazole, N-butylimidazole, 1-(2-hydroxyethyl)imidazole, 2-ethyl-4-methylimidazole, 1,2-dimethylimidazole, 1-benzyl-2-methylimidazole, 1-cyanoethyl-2-methylimidazole, 1-cyanoethyl-2-ethyl-4-methylimidazole, 2-phenyl-4,5-dihydroxymethylimidazole, 1-acetylimidazole, and 2-hydroxybenzimidazole.

Examples of the nitrogen-containing aromatic compounds include pyridine, $\alpha$-picoline, $\beta$-picoline, $\gamma$-picoline, 2,6-lutidine, 2,3-lutidine, pyrazine, 2-hydroxypyrazine, pyrimidine, 2-hydroxypyrimidine, 4-hydroxypyrimidine, pyridazine, 3-hydroxypyridazine, 4-hydroxypyridazine, triazine, and 2-hydroxytriazine.

The basic compound contained in the paste is preferably a chelate-coordinating basic compound having an ethylenediamine structure or an ethanolamine structure in the molecular structure from the viewpoint that the metal ion produced when a metal oxide on the surfaces of the metal particles is dissolved is easily stabilized by chelate coordination. The amino group in the above structure may be any one of primary to tertiary amino groups, and is preferably a tertiary amino group from the viewpoint of suppressing a side reaction between the basic compound and the reducing organic substance.

The basic compound preferably contains an alkylamine having at least one linear alkyl group having from 1 to 20 carbon atoms (preferably from 1 to 15 carbon atoms) together with the chelate-coordinating basic compound.

In the paste, a molar ratio of a basic group of the basic compound to an acidic group of the reducing organic substance (basic group/acidic group) is 0.4 or more, preferably 0.5 or more, more preferably 0.6 or more, still more preferably 1.0 or more, and particularly preferably 1.6 or more. When the molar ratio is less than 0.4, a reaction with the metal by the acidic group of the reducing organic substance proceeds, the metal paste becomes a solid in an aggregated state, and the paste state may not be maintained. The molar ratio is preferably 2.0 or less, more preferably 1.8 or less, and still more preferably 1.7 or less. When the molar ratio is 2.0 or less, the surfaces of the metal particles are easily reduced, and the sintered body is enhanced in conductivity. The number of moles of the acidic group contained in the reducing organic substance is calculated by multiplying the number of moles of the reducing organic substance by the number of acidic groups contained in the reducing organic substance, and the number of moles of the basic group contained in the basic compound is calculated by multiplying the number of moles of the basic compound by the number of basic groups contained in the basic compound.

The content proportion of the basic compound in the paste is preferably from 0.1 to 10 mass%, more preferably

from 0.3 to 9 mass%, and still more preferably from 0.5 to 8 mass%, with respect to the total amount (100 mass%) of the paste.

Coordinating Organic Compound

The coordinating organic compound is a compound that coordinates to the metal surfaces of the metal particles, and is a compound excluding the compound corresponding to the basic compound. The coordinating organic compound preferably has a boiling point higher than that of at least one of the reducing organic substances. In this case, the coordinating organic compound remains more than the reducing organic substance at the time of firing, and the contact between the reducing organic substance and the active metal surface is easily suppressed; and thus, the decomposition of the reducing organic substance is suppressed.

Examples of the coordinating organic compound include at least one compound selected from the group consisting of a compound having a carboxyl group, compounds having a ketone group (for example, diketones such as acetylacetone, and β-ketoesters), a compound having a hydroxy group, a compound having a sulfo group, and a compound having a thiol group. Among them, a compound having a carboxyl group is preferable from the viewpoint of facilitating precipitation of the dissolved metal oxide as small-sized metal particles.

The compound having a carboxyl group is preferably a monovalent or divalent carboxylic acid, and more preferably a monovalent carboxylic acid from the viewpoint of facilitating sintering of the metal particle aggregate in a later process.

The carboxylic acid may be the same as the carboxylic acid described for the reducing organic substance. From the viewpoint of easy availability and low toxicity and odor, a carboxylic acid having from 2 to 15 carbon atoms (preferably from 5 to 12, and more preferably from 8 to 10) may be used. Specific examples thereof include acetic acid (boiling point: 118°C), lactic acid (boiling point: 122°C), propionic acid (boiling point: 141°C), acrylic acid (boiling point: 141°C), malic acid (boiling point: 167°C), pentanoic acid (boiling point: 186°C), n-hexanoic acid (boiling point: 205°C), heptanoic acid (boiling point: 223°C), 2-ethylhexanoic acid (boiling point: 228°C), succinic acid (boiling point: 235°C), n-octanoic acid (boiling point: 237°C), nonanoic acid (boiling point: 254°C), decanoic acid (boiling point: 269°C), dodecanoic acid (boiling point: 299°C), tartaric acid (boiling point: 275°C), and oxalic acid (boiling point: 365°C). Since the carboxylic acid functions as the reducing organic substance and the coordinating organic compound, when the carboxylic acid is used as the coordinating organic compound, one carboxylic acid having the lowest boiling point may be used in combination with another carboxylic acid having a boiling point higher than that of the one carboxylic acid. In this case, the carboxylic acid having a relatively high boiling point mainly acts as a protective agent, and the carboxylic acid having a relatively low boiling point acts as a reducing agent.

The boiling point of the carboxylic acid at normal pressure is preferably higher than 110°C, more preferably 150°C or higher, and even more preferably 200°C or higher, from the viewpoint of being less volatile than formic acid (boiling point: 101°C).

In the paste, a ratio of the number of moles of the coordinating functional group contained in the coordinating organic compound to the number of moles of the acidic group contained in the reducing organic substance (coordinating functional group/acidic group) is preferably from 0.05 to 1.20, more preferably from 0.40 to 1.10, and still more preferably from 0.50 to 0.70. When the molar ratio is 0.05 or more, the small-sized metal particles are easily precipitated, and when the molar ratio is 1.20 or less, the coordinating organic compound is less likely to remain at the time of firing.

In the paste, a molar ratio of the number of moles of the coordinating functional group contained in the coordinating organic compound to the basic group of the basic compound (coordinating functional group/basic compound) is preferably from 0.10 to 1.00, more preferably from 0.15 to 0.75, and still more preferably from 0.20 to 0.60. When the molar ratio is 0.10 or more, the small-sized metal particles are easily precipitated, and when the molar ratio is 1.00 or less, the coordinating organic compound is less likely to remain at the time of firing.

The content proportion of the coordinating organic compound in the paste is preferably from 0.1 to 10 mass%, more preferably from 0.2 to 9 mass%, and still more preferably from 0.3 to 8 mass%, with respect to the total amount (100 mass%) of the paste.

<Resin>

Examples of the resin described above include thermoplastic resins (for example, polyester-based resins, polyamide-based resins, polyurethane-based resins, polyimide-based resins, polyolefin-based resins, (meth)acrylic resins, styrene-based resins, halogen-containing vinyl-based resins, polyvinyl acetal-based resins, cellulose-based resins (such as ethyl cellulose resins and alkyl cellulose resins), and thermoplastic silicone resins) and thermosetting resins (for example, epoxy resins, unsaturated polyester resins, diallyl phthalate resins, and silicone resins). Among them, a thermoplastic resin is preferable from the viewpoint of alleviating internal stress at the time of heating, and a (meth)acrylic resin and a polyvinyl acetal-based resin are preferable from the viewpoint of adhesion to a base material and strength of the

metal particle aggregate.

Examples of the polyvinyl acetal-based resin include polyvinyl butyral.

The content proportion of the resin in the paste is preferably 1.0 mass% or less, more preferably from 0.05 to 1.0 mass%, and still more preferably from 0.1 to 0.9 mass%, with respect to the total amount (100 mass%) of the paste.

Organic Solvent

The paste may contain an organic solvent to adjust fluidity (viscosity) or workability. Preferably, the organic solvent contains at least an organic solvent (a), an organic solvent (b), and an organic solvent (c). The organic solvent (a), the organic solvent (b), and the organic solvent (c) are different compounds each other and satisfy the following Formulas (1) to (6). Only one type of each of the organic solvent (a), the organic solvent (b), and the organic solvent (c) may be used alone, or two or more types thereof may be used.

$$150°C \leq Ta \leq 250°C \ (1)$$

$$150°C \leq Tb \leq 250°C \ (2)$$

$$250°C \leq Tc \leq 350°C \ (3)$$

$$\delta a \geq 10.0 \ (4)$$

$$\delta c \leq 9.0 \ (5)$$

$$\delta c \leq \delta b \leq \delta a \ (6)$$

In Formulas, Ta to Tc represent the boiling points of the organic solvents (a) to (c), respectively, and δa to δc represent the Hansen solubility parameters of the organic solvents (a) to (c), respectively. In the present specification, the Hansen solubility parameter may be referred to as "SP value" and described as "δ".

The organic solvents (a) to (c) only need to be uniformly dissolved to form a liquid state when mixed at blending proportions used in the bonding conductive paste, and may each, independently, be in a liquid state or a solid state at room temperature.

The organic solvent (a) satisfies at least Formula (1). That is, the boiling point Ta of the organic solvent (a) is 150°C or more and 250°C or less, preferably more than 150°C and less than 250°C, more preferably 155°C or more and 220°C or less, and even more preferably 160°C or more and 200°C or less. When the organic solvent (a) having a boiling point within the above range is used, the organic solvent is easily volatilized during sintering, and a sintered body can be easily formed.

The organic solvent (a) satisfies at least Formula (4) [δa ≥ 10.0]. The SP value δa of the organic solvent (a) is 10.0 or more, preferably 10.3 or more, and more preferably 10.4 or more as long as the SP value δa satisfies Formula (6). When the δa is 10.0 or more, excellent dispersibility of the particles described above and Ag and/or Cu powder described below is achieved, and separation of the metal particles from the organic solvent can be suppressed. The δa of the organic solvent (a) is, for example, 16.0 or less and may be 15.0 or less.

Examples of the organic solvent (a) include an alcohol solvent, a urea-based solvent, and an aprotic polar solvent. Examples of the alcohol solvent include compounds having one or more hydroxy groups. Among them, a tertiary alcohol and an ether alcohol are preferred. The alcohol solvent may have two or more hydroxy groups. The ether alcohol is a compound having an ether bond and a hydroxy group, and examples thereof include a (poly)alkylene glycol monoalkyl ether and an alkoxy group-substituted alcohol.

Specific examples of the organic solvent (a) include pinacol (δ 10.7, boiling point 172°C), tetramethylurea (δ 10.6, boiling point 177°C), 3-methoxybutanol (δ 10.6, boiling point 161°C), 1-methylcyclohexanol (δ 10.4, boiling point 155°C), and methyl carbitol (diethylene glycol monomethyl ether) (δ 10.7, boiling point 193°C).

The organic solvent (b) satisfies at least Formula (2). That is, the boiling point Tb of the organic solvent (b) is 150°C or more and 250°C or less, preferably more than 150°C and less than 250°C, more preferably 180°C or more and 248°C or less, and even more preferably 200°C or more and 245°C or less. When the organic solvent (b) having a boiling point within the above range is used, the organic solvent is easily volatilized during sintering and a sintered body can be easily formed. When the organic solvent (b) having a boiling point of 250°C or lower is used, void generation during sintering can be suppressed.

The organic solvent (b) satisfies at least Formula (6). The SP value δb of the organic solvent (b) is preferably from 8.0 to 12.0, more preferably from 8.5 to 11.0, and even more preferably from 9.0 to 10.5 as long as the SP value δb satisfies Formula (6). When the δb is within the above range, there is a tendency that the miscibility between the organic solvent (a) and the organic solvent (c) is improved, separation is less likely to occur, and continuous discharge stability and storage stability are further enhanced.

Examples of the organic solvent (b) include an alcohol solvent, an ester solvent, a ketone solvent, and an amine-based solvent. Examples of the alcohol solvent include solvent compounds having one or more hydroxy groups. Among them, a tertiary alcohol, an ether alcohol, and an ester alcohol are preferred. The ether alcohol is a compound having an ether bond and a hydroxy group, and examples thereof include a (poly)alkylene glycol monoalkyl ether and an alkoxy group-substituted alcohol. The ester alcohol is a compound having an ester bond and a hydroxy group, and examples thereof include (poly)alkylene glycol monoalkyl ether monoesters. Examples of the ester solvent include diacetates of diols such as (poly)alkylene glycols. The ketone solvent is preferably a cyclic ketone. The amine-based solvent is preferably an alkylamine.

The organic solvent (b) is selected on the premise that the organic solvent (b) satisfies Formula (6) in the relationship with the organic solvents (a) and (c). Specific examples of the organic solvent (b) that can be used include d-Camphor (camphor) (δ 10.4, boiling point 204°C), 1-heptanol (δ 10.0, boiling point 177°C), butyl carbitol (diethylene glycol monobutyl ether) (δ 10.2, boiling point 231°C), ethyl carbitol (diethylene glycol monoethyl ether) (δ 10.5, boiling point 196°C), tripropylene glycol monomethyl ether (δ 9.4, boiling point 243°C), α-terpineol (δ 9.3, boiling point 220°C), dihydroterpineol (δ 9.0, boiling point 210°C), 1,3-butanediol diacetate (δ 9.2, boiling point 232°C), propylene glycol diacetate (δ 9.3, boiling point 190°C), butyl carbitol acetate (δ 9.0, boiling point 247°C), dipropylene glycol butyl ether (δ 9.2, boiling point 230°C), isophorone (δ 9.5, boiling point 213°C), 1-decanol (δ 9.6, boiling point 230°C), propylene glycol monobutyl ether (δ 9.0, boiling point 170°C), and 1-nonanol (δ 9.8, boiling point 214°C).

Preferably, the boiling point Tb of the organic solvent (b) is higher than the boiling point Ta of the organic solvent (a), that is, Tb > Ta. The temperature difference between Tb and Ta [Tb - Ta] is preferably 2°C or more, more preferably 5°C or more, and even more preferably 10°C or more. When the temperature difference is 2°C or more, void generation during sintering can be further suppressed.

The organic solvent (c) satisfies at least Formula (3). That is, the boiling point Tc of the organic solvent (c) is 250°C or more and 350°C or less, preferably more than 250°C and less than 350°C, more preferably more than 250°C and 320°C or less, and even more preferably more than 250°C and 300°C or less. When the organic solvent (c) having a boiling point within the above range is used, rapid volatilization of the organic solvent (a) and the organic solvent (b) and void generation can be suppressed during sintering.

The organic solvent (c) satisfies at least Formula (5) [δc ≤ 9.0]. The SP value δc of the organic solvent (c) is 9.0 or less, preferably 8.7 or less, and more preferably 8.5 or less. When the δc is 9.0 or less, void generation during sintering can be suppressed. The δc of the organic solvent (c) is, for example, 6.0 or more and may be 7.0 or more.

Examples of the organic solvent (c) include an ether solvent, an alkane solvent, and an ester solvent. Examples of the ether solvent include (poly)alkylene glycol dialkyl ethers. The alkane solvent is preferably an alkane having 14 or more carbons (for example, from 14 to 20 carbons). Examples of the ester solvent include esters of (poly)alkylene glycol alkyl ethers and fatty acids.

Specific examples of the organic solvent (c) include dibutyl carbitol (diethylene glycol dibutyl ether) (δ 8.3, boiling point 255°C), tetradecane (δ 7.9, boiling point 254°C), and hexadecane (δ 8.0, boiling point 287°C).

Preferably. the boiling point Tc of the organic solvent (c) is higher than the boiling point Tb of the organic solvent (b), that is, Tc > Tb. The temperature difference between Tc and Tb [Tc - Tb] is preferably 2°C or more, more preferably 6°C or more, and even more preferably 10°C or more. When the temperature difference is 2°C or more, void generation during sintering can be further suppressed.

Preferably, the boiling point Tc of the organic solvent (c) is higher than the boiling point Ta of the organic solvent (a), that is, Tc > Ta. The temperature difference between Tc and Ta [Tc - Ta] is preferably 30°C or more, more preferably 50°C or more, and even more preferably 60°C or more. When the temperature difference is 30°C or more, void generation during sintering can be further suppressed.

The SP value δa of the organic solvent (a), the SP value δb of the organic solvent (b), and the SP value δc of the organic solvent (c) satisfy Formula (6) above [δc ≤ δb ≤ δa]. In particular, preferably, δb is preferably higher than δc, that is, δc < δb is satisfied. In addition, preferably, δa is higher than δb, that is, δb < δa is satisfied.

The difference between δb and δc [δb - δc] is preferably 0.1 or more, more preferably 0.2 or more, and even more preferably 0.5 or more. When the difference is 0.1 or more, the dispersibility of the metal particles is further enhanced, and the continuous discharge stability is further enhanced. The difference is preferably 2.0 or less, more preferably 1.5 or less, and even more preferably 1.3 or less. When the difference described above is 2.0 or less, the particles described above and Ag and/or Cu powder described below and the organic solvent are less likely to be separated, and the continuous discharge stability and the storage stability are further enhanced.

The difference between δa and δb [δa - δb] is preferably 0.1 or more, more preferably 0.2 or more, and even more

preferably 0.5 or more. When the difference is 0.1 or more, the dispersibility of the metal particles is further enhanced, and the continuous discharge stability is further enhanced. The difference is preferably 2.5 or less, more preferably 2.0 or less, and even more preferably 1.8 or less. When the difference described above is 2.5 or less, the metal particles and the organic solvent are less likely to be separated, and the continuous discharge stability and the storage stability are further enhanced.

The difference between $\delta a$ and $\delta c$ [$\delta a - \delta c$] based on Formulas (4) and (5) is 1.0 or more, preferably 1.5 or more, and more preferably 2.0 or more. When the above difference is 1.0 or more, void generation during sintering can be further suppressed. The above difference is preferably 5.0 or less, more preferably 4.0 or less, and even more preferably 3.0 or less. When the above difference is 5.0 or less, the particles described above and Ag and/or Cu powder described below and the organic solvent are less likely to be separated, and the continuous discharge stability and the storage stability are further enhanced.

The proportion of the organic solvent (a) relative to 100 mass% of the total amount of the organic solvent (a), the organic solvent (b), and the organic solvent (c) [organic solvent (a)/ {organic solvent (a) + organic solvent (b) + organic solvent (c)}] is preferably from 5 to 70 mass%, more preferably from 10 to 60 mass%, and even more preferably from 15 to 50 mass%. When the proportion is within the above range, the organic solvent is easily volatilized during sintering, a sintered body can be easily formed, and the dispersibility of the particles described above and Ag and/or Cu powder described below is further enhanced.

The proportion of the organic solvent (b) relative to 100 mass% of the total amount of the organic solvent (a), the organic solvent (b), and the organic solvent (c) [organic solvent (b)/ {organic solvent (a) + organic solvent (b) + organic solvent (c)}] is preferably from 5 to 70 mass%, more preferably from 10 to 60 mass%, and even more preferably from 15 to 50 mass%. When the proportion is within the above range, the miscibility among the organic solvents is enhanced, and continuous discharge stability and storage stability are further enhanced.

The proportion of the organic solvent (c) relative to 100 mass% of the total amount of the organic solvent (a), the organic solvent (b), and the organic solvent (c) [organic solvent (c)/ {organic solvent (a) + organic solvent (b) + organic solvent (c)}] is preferably from 5 to 70 mass%, more preferably from 10 to 60 mass%, and even more preferably from 15 to 50 mass%. When the proportion is within the above range, void generation during sintering can be further suppressed.

The content of the organic solvent (c) relative to 100 parts by mass of the organic solvent (a) is preferably from 20 to 400 parts by mass, more preferably from 30 to 300 parts by mass, and even more preferably from 50 to 200 parts by mass. When the content is within the above range, the blending amounts of the organic solvent (a) and the organic solvent (c) are well balanced, and void suppression during sintering and the dispersibility of the particles described above and Ag and/or Cu powder described below are further improved.

The content of the organic solvent (b) relative to 100 parts by mass of the total amount of the organic solvent (a) and the organic solvent (c) is preferably from 10 to 200 parts by mass, more preferably from 20 to 150 parts by mass, and even more preferably from 40 to 100 parts by mass. When the content is within the above range, the miscibility between the organic solvent (a) and the organic solvent (c) is further improved, and continuous discharge stability and low-temperature storage property are further enhanced.

The organic solvent may contain an additional solvent (organic solvent) besides the organic solvent (a), the organic solvent (b), and the organic solvent (c). The total content proportion of the organic solvent (a), the organic solvent (b), and the organic solvent (c) in the organic solvent is preferably 50 mass% or more, more preferably 70 mass% or more, even more preferably 80 mass% or more, still more preferably 90 mass% or more, and particularly preferably 95 mass% or more, relative to 100 mass% of total amount of the organic solvent. When the content proportion described above is 50 mass% or more, the dispersibility of the particles described above and Ag and/or Cu powder described below and the miscibility among the organic solvents are further enhanced, and continuous discharge stability, storage stability, and void formation suppression during sintering are further enhanced.

When the organic solvent (a), the organic solvent (b), and the organic solvent (c) are mixed in blending proportions used in the bonding conductive paste, it is preferable that the organic solvent (a), the organic solvent (b), and the organic solvent (c) are homogeneously dissolved at normal temperature and do not cause phase separation. In the bonding conductive paste, it is preferable that the organic solvent (a), the organic solvent (b), and the organic solvent (c) are homogeneously dissolved at normal temperature and do not cause phase separation. In particular, it is preferable that the phase separation does not occur at 22 to 28°C (preferably at 10 to 30°C and more preferably at 0 to 35°C).

The content of the organic solvent in the paste is preferably from 0.5 to 30 parts by mass or less, and more preferably from 2 to 20 parts by mass or less, with respect to 100 parts by mass of total of the particles, the organic substance other than the organic solvent, and the Ag and/or Cu powder.

Furthermore, the paste preferably contains an Ag and/or Cu powder in addition to the particles. In particular, when the particles contain Ag as the metal element X, an Ag powder is preferably contained. When the particles contain Cu as the metal element X, a Cu powder is preferably contained.

The average particle size (median diameter) of the Ag and/or Cu powder is preferably from 0.1 to 100 μm, more preferably from 0.3 to 50 μm, and even more preferably from 0.5 to 10 μm. When the average particle size is 0.1 μm or

more, handling is facilitated. Bonding reliability is easily exhibited by setting the average particle size to 100 μm or less.

The shape of the Ag and/or Cu powder is not particularly limited. Examples thereof include a spherical shape, a flake shape (flat shape), and a polyhedral shape. Only particles having the same shape may be used, or particles having different shapes may be used in combination. Among these, a spherical shape is preferred for proper dispersion in the paste.

The content of the Ag and/or Cu powder is preferably from 5 to 2000 parts by mass, more preferably from 20 to 1500 parts by mass, even more preferably from 30 to 1200 parts by mass, and particularly preferably from 50 to 1000 parts by mass, with respect to 100 parts by mass of the particles. When the content of the Ag and/or Cu powder is 5 parts by mass or more, sufficient bonding to alloy particles can be performed at the time of sintering bonding. When the content is 2000 parts by mass or less, the coefficient of linear expansion can be easily reduced.

Furthermore, the paste may contain an additional component other than the components described above. Examples of the additional component include a surfactant other than the organic substance, and a viscosity modifier other than the organic substance. The content of the additional component is preferably 5 mass% or less, and may be 3 mass% or less, with respect to 100 mass% of the total amount of the organic substance.

## Preform

As an embodiment of the present disclosure, there can be provided a preform containing the alloy. The preform is a material obtained by molding the alloy, the particles, the alloy ribbon, or the paste into a particular shape.

The shape of the preform is not particularly limited and examples thereof include a sheet shape, a spherical shape, a ring shape, a cylindrical shape, a ribbon shape, a square shape, a disk shape, a washer shape, a chip shape, and a wire shape. A sheet shape and a spherical shape are particularly preferred.

## Sintered Body

As an embodiment of the present disclosure, there can provided a sintered body containing the alloy. FIG. 1 is an SEM photograph in which a sintered body of the alloy is magnified. Deposition of the metal element X (nodules) can be observed on the surface of the sintered body. By allowing the metal element X to be deposited, the sintered body and a surrounding alloy and/or member to be bonded can be easily bonded.

## Production Method of Sintered Body

Furthermore, as an embodiment of the present disclosure, there can be provided a method for producing a sintered body of the alloy. As the method for producing the sintered body, the production can be performed by heat treating the alloy in a gas phase, liquid phase, or solid phase atmosphere forming a compound with the metal element Y. Among these, the heat treatment is performed more preferably in an oxygen atmosphere. When the heat treatment is performed in an oxygen atmosphere, the oxygen concentration is preferably from 0.01 to 30%, more preferably from 0.05 to 25%, and even more preferably from 0.1 to 21%. When the oxygen concentration is 0.01% or more, the metal element X can be deposited while the metal element Y is oxidized. Furthermore, when the oxygen concentration is 30% or less, the oxidation rate of the metal element Y can be made moderate.

Furthermore, the temperature (sintering temperature) of the heat treatment is preferably from 150 to 500°C, more preferably from 180 to 450°C, and even more preferably from 200 to 400°C. Furthermore, the heat treatment time (sintering time) is, for example, preferably from 10 seconds to 2 hours, and more preferably from 3 minutes to 1 hour. Furthermore, the sintered body may be sintered without application of pressure or may be sintered under pressure. When pressure is applied, the pressure is, for example, from 0.3 to 40 MPa.

## Bonding Body

The sintered body can be used as a bonding body for bonding members to be bonded. For example, the preform is applied or loaded between two members to be bonded, the organic substance is optionally volatilized by, for example, heating, the preform is sintered in the presence of oxygen by heating, application of pressure, irradiation with active energy rays, or the like, and thus a bonding body bonding the members to be bonded can be obtained. Examples of the members to be bonded include a substrate and an electronic component. That is, the bonding body may be used for bonding substrates to each other or may be used for bonding a substrate and an electronic component.

The thickness of the bonding body is preferably from 5 μm to 500 μm, more preferably from 20 to 300 μm, and even more preferably from 40 to 150 μm.

[Electronic device]

As an embodiment of the present disclosure, there is provided an electronic device including the sintered body and/or the bonding body. In the electronic device, a member to be bonded is bonded to a substrate by interposing the sintered body and/or the bonding body between the member to be bonded and the substrate. FIG. 2 is a cross-sectional view schematically illustrating this electronic device. Reference numeral 1 denotes the electronic device, 10 denotes the substrate, 20 denotes the bonding body, and 30 denotes the member to be bonded.

Examples of the substrate include a metal substrate such as a copper substrate, a ceramic substrate, a metal-adhered ceramic substrate, a SiC substrate, a gallium nitride substrate, a glass-epoxy substrate, a BT resin substrate, a glass substrate, and a resin substrate. Since the alloy of the present disclosure can be sintered at a relatively low temperature, the alloy can be also used for a substrate sensitive to heat. As the substrate, a ceramic substrate and a metal-adhered ceramic substrate are preferred, and a copper-adhered ceramic substrate and an aluminum-adhered ceramic substrate are more preferred.

Examples of the member to be bonded include an electronic component and a heat dissipation board. Examples of the electronic component include electronic elements (chip, die) such as a semiconductor element and an LED element. Specific examples of the semiconductor element include a power semiconductor element. Furthermore, a bonding face of the member to be bonded to the bonding layer is preferably silver-plated. Examples of the material of the member to be bonded include silicon (Si), silicon carbide (SiC), GaN, and diamond.

The electronic device can be produced by applying the alloy on a substrate by a printing method (specifically, for example, a dispenser printing method, a mask printing, a screen printing method, and an inkjet printing method), loading a member to be bonded on the applied layer, and then subjecting the resultant to sintering.

As the sintering condition, the sintering can be performed in the same conditions as those described for the method for producing the sintered body described above.

In the sintering, the metal element X in the alloy is deposited, and thus the substrate and/or the member to be bonded can be firmly bonded. Thus, the electronic device including the sintered body and/or the bonding body has excellent bonding reliability while can be easily formed.

Each aspect disclosed in the present specification can be combined with any other feature disclosed in the present specification. Moreover, each of the configurations, combinations thereof, and the like in each of the embodiments are merely illustrative, and various additions, omissions, and other changes of the configurations may be made, as appropriate, without departing from the spirit of the present disclosure. The present disclosure is not limited by the embodiments and is limited only by the claims.

Example

An embodiment of the present disclosure will be described in more detail below based on Examples.

Example 1

A mixture of 84 mol% (95 mass%) of silver (Ag) ingot (purity: 99.99%) and 16 mol% (5 mass%) of silicon (Si) ingot (purity: 99.9999%) was prepared, and heated and melted at 1450°C. The obtained solution was rapidly cooled by using a gas atomizer (product name "RQP-20K", available from Makabe R&D Co., Ltd.) to form a powder, and thus alloy particles of Example 1 having an average particle size of 5 μm were obtained. Note that, in the alloy particles of Example 1, a proportion of 5 mol of Si was dissolved into 100 mol of Ag as solid solution.

Example 2

A powder was obtained by the same method as that of Example 1 except that a mixture of 89 mol% (97 mass%) of silver (Ag) ingot (purity: 99.99%) and 11 mol% (3 mass%) of silicon (Si) ingot (purity: 99.9999%) was prepared. The powder was classified such that the average particle size was 20 μm or less, by using an ultrasonic vibration sieving machine (product name "TSK-DGD type", available from Tokyo Screen Co., Ltd.), and thus alloy particles of Example 2 were obtained. Note that it was confirmed that Si was dissolved in Ag as a solid solution in the alloy particles of Example 2.

Example 3

A mixture of 89 mol% (97 mass%) of silver (Ag) ingot (purity: 99.99%) and 11 mol% (3 mass%) of silicon (Si) ingot (purity: 99.9999%) was prepared, and heated and melted at 1450°C. The obtained solution was rapidly cooled by using a liquid rapid solidification equipment (product name "RQP-20K", available from Nisshin Giken Co., Ltd.), and thus an alloy ribbon of Example 3 was prepared. Note that it was confirmed that Si was dissolved in Ag as a solid solution in the alloy

ribbon of Example 3.

Comparative Example 1

A mixture of 89 mol% (97 mass%) of silver (Ag) ingot (purity: 99.99%) and 11 mol% (3 mass%) of silicon (Si) ingot (purity: 99.9999%) was prepared, and heated and melted at 1450°C. The obtained solution was gradually cooled in a test tube, and thus an ingot of Comparative Example 1 was prepared. Note that it was not confirmed that Si was dissolved in Ag as a solid solution in the ingot of Comparative Example 1.

[Table 1]

Table 1

| | | Example 1 | Example 2 | Example 3 | Comparative Example 1 |
|---|---|---|---|---|---|
| Alloy composition | Ag mol% | 84 | 89 | 89 | 89 |
| | Si mol% | 16 | 11 | 11 | 11 |
| | Ag mass% | 95 | 97 | 97 | 97 |
| | Si mass% | 5 | 3 | 3 | 3 |
| Shape | Particles of 5 µm | Particles of 20 µm or less | Ribbon | Ingot | |

Evaluation

Raw materials of Examples and Comparative Example were sintered for 1 hour under the respective conditions described in Table 2, and thus sintered bodies were prepared. Note that, in the case of the oxygen concentration of 0%, the sintered body was prepared by sintering under the condition where the nitrogen concentration was 100%.

Each of the sintered bodies described above was imaged by SEM at a magnification of 3000 times. A case where nodules were observed on the surface was evaluated as "o", and a case where nodules were not observed was evaluated as "×". The results are shown in Table 2.

Table 2

| Used raw material | Example 1 | | | Example 2 | | | Example 3 | | Comparative Example 1 |
|---|---|---|---|---|---|---|---|---|---|
| Oxygen concentration (%) | 0 | 0.1 | 21 | 21 | 0.1 | 21 | 21 | 21 | 21 |
| Temperature (°C) | 280 | 280 | 280 | 250 | 340 | 410 | 250 | 320 | 320 |
| Occurrence of nodules | × | ○ | ○ | ○ | ○ | ○ | ○ | ○ | × |

It was confirmed that the metal element X was deposited on the surface by heating the alloy of each of Examples in the presence of oxygen. On the other hand, in the case where the solid solution phase of the metal element Y in the metal element X was not contained (Comparative Example 1), it was confirmed that the metal element X was not deposited on the surface even when the heating is carried out in the presence of oxygen.

Hereinafter, variations of the present disclosure will be described.

[Appendix 1]

An alloy containing a solid solution phase of a metal element Y in a metal element X,
the metal element X being deposited on a surface by heat treatment in a gas phase, liquid phase, or solid phase atmosphere forming a compound with the metal element Y.

[Appendix 2]

The alloy according to Appendix 1, wherein the metal element X is deposited on the surface by the heat treatment in a gas phase atmosphere.

[Appendix 3]

The alloy according to Appendix 1 or 2, wherein the metal element X is deposited on the surface by the heat treatment in an oxygen atmosphere.

[Appendix 4]

The alloy according to any one of Appendixes 1 to 3, wherein the solid solution phase is present on the alloy surface.

[Appendix 5]

The alloy according to any one of Appendixes 1 to 4, wherein a proportion of the solid solution phase in the entire alloy surface (100%) is 10% or more.

[Appendix 6]

The alloy according to any one of Appendixes 1 to 5, wherein a proportion of the solid solution phase in 100 mass% of the total amount of the alloy is 3 mass% or more.

[Appendix 7]

The alloy according to any one of Appendixes 1 to 6, wherein the metal element X is Ag and/or Cu.

[Appendix 8]

The alloy according to Appendix 7, wherein the metal element X contains Ag and the metal element Y contains Si and/or Ge.

[Appendix 9]

The alloy according to Appendix 7, wherein the metal element X contains Cu and the metal element Y contains W and/or Cr.

[Appendix 10]

The alloy according to any one of Appendixes 1 to 9, wherein the alloy contains the metal element Y that is in a supersaturated solid solution in the metal element X.

[Appendix 11]

The alloy according to any one of Appendixes 1 to 10, wherein a molar ratio of the metal element X to the metal element Y [metal element X/metal element Y] is from 95/5 to 10/90.

[Appendix 12]

The alloy according to any one of Appendixes 1 to 11, wherein a content of the metal element X is preferably from 1 to 99 mass%, more preferably from 10 to 98 mass%, and even more preferably from 50 to 97 mass%, with respect to 100 mass% of the alloy.

[Appendix 13]

The alloy according to any one of Appendixes 1 to 12, wherein the content of the metal element Y is preferably from 1 to 99 mass%, more preferably from 2 to 90 mass%, and even more preferably from 3 to 50 mass%, with respect to 100 mass% of the alloy.

[Appendix 14]

A particle containing the alloy described in any one of Appendixes 1 to 13.

[Appendix 15]

The particle according to Appendix 14, wherein the particle has an average particle size of 0.1 to 100 μm.

[Appendix 16]

An alloy ribbon containing the alloy described in any one of Appendixes 1 to 13.

[Appendix 17]

The alloy ribbon according to Appendix 16, wherein the alloy ribbon has a thickness of 1 μm to 2 mm.

[Appendix 18]

The alloy ribbon according to Appendix 16 or 17, wherein the alloy ribbon has a width of 0.1 to 100 mm.

[Appendix 19]

A paste containing the particle described in Appendix 14 or 15, an organic substance, and an Ag powder and/or a Cu powder.

[Appendix 20]

A preform containing the alloy described in any one of Appendixes 1 to 13.

[Appendix 21]

The preform according to Appendix 20, wherein the preform is in a sheet shape or a spherical shape.

[Appendix 22]

A sintered body of the alloy described in any one of Appendixes 1 to 13.

[Appendix 23]

A bonding body including the sintered body described in Appendix 22.

[Appendix 24]

A substrate including the bonding body described in Appendix 23.

[Appendix 25]

An electronic device including the bonding body described in Appendix 23 or 24.

[Appendix 26]

A method for producing a sintered body, the method including heat treating the alloy described in any one of Appendixes 1 to 13 in a gas phase, liquid phase, or solid phase atmosphere forming a compound with the metal element Y.

[Appendix 27]

The method for producing a sintered body described in Appendix 26, the method including performing the heat treatment in an oxygen atmosphere.

[Appendix 28]

The method for producing a sintered body described in Appendix 27, wherein an oxygen concentration at the time of the heat treatment is from 0.01 to 30%.

Reference Signs List

1 Electronic device

10 Substrate

20 Bonding body

30 Member to be bonded

## Claims

1. An alloy comprising a solid solution phase of a metal element Y in a metal element X,
the metal element X being deposited on a surface by heat treatment in a gas phase, liquid phase, or solid phase atmosphere forming a compound with the metal element Y.

2. The alloy according to claim 1, wherein the metal element X is deposited on the surface by the heat treatment in an oxygen atmosphere.

3. The alloy according to claim 1 or 2, wherein the metal element X is Ag and/or Cu.

4. The alloy according to claim 3, wherein the metal element X contains Ag and the metal element Y contains Si and/or Ge.

5. The alloy according to claim 3, wherein the metal element X contains Cu and the metal element Y contains W and/or Cr.

6. The alloy according to claim 1 or 2, wherein the alloy contains the metal element Y that is in a supersaturated solid solution in the metal element X.

7. The alloy according to claim 1 or 2, wherein a molar ratio of the metal element X to the metal element Y [metal element X/metal element Y] is from 95/5 to 10/90.

8. A particle comprising the alloy described in claim 1 or 2.

9. The particle according to claim 8, wherein the particle has an average particle size of 0.1 to 100 μm.

10. An alloy ribbon comprising the alloy described in claim 1 or 2.

11. A paste comprising the particle described in claim 8, an organic substance, and an Ag powder and/or a Cu powder.

12. A preform comprising the alloy described in claim 1 or 2.

13. The preform according to claim 12, wherein the preform is in a sheet shape or a spherical shape.

14. A sintered body of the alloy described in claim 1 or 2.

15. A bonding body comprising the sintered body described in claim 14.

16. A substrate comprising the bonding body described in claim 15.

**17.** An electronic device comprising the bonding body described in claim 15.

**18.** A method for producing a sintered body, the method comprising heat treating the alloy described in claim 1 or 2 in a gas phase, liquid phase, or solid phase atmosphere forming a compound with the metal element Y.

**19.** The method for producing a sintered body according to claim 18, the method comprising performing the heat treatment in an oxygen atmosphere.

**20.** The method for producing a sintered body according to claim 19, wherein an oxygen concentration at the time of the heat treatment is from 0.01 to 30%.

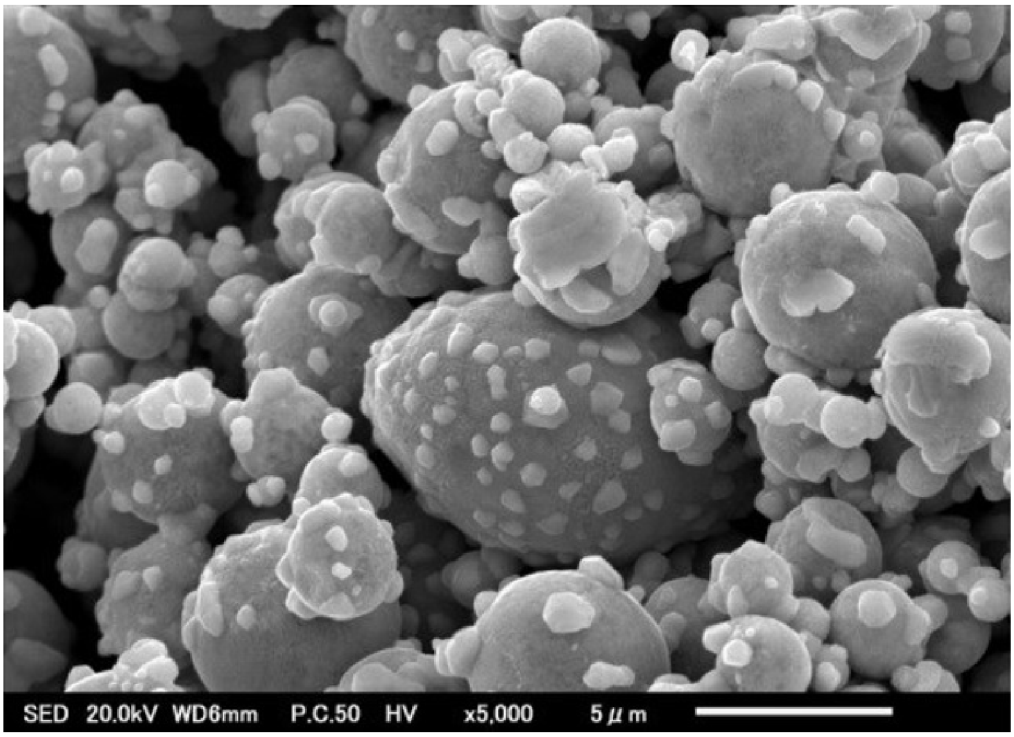


FIG. 1

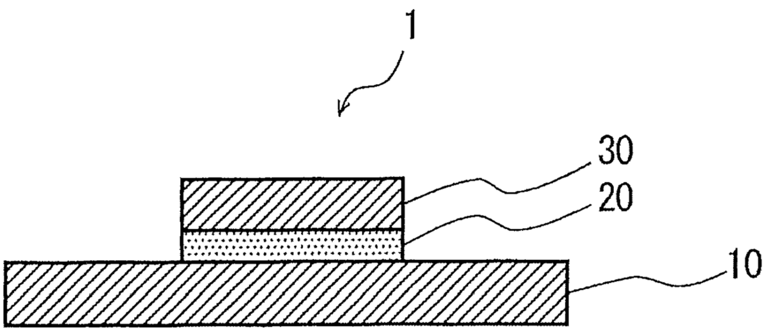


FIG. 2

**INTERNATIONAL SEARCH REPORT**

International application No.
**PCT/JP2024/031632**

**A. CLASSIFICATION OF SUBJECT MATTER**

***C22C 5/06***(2006.01)i; ***B22F 1/00***(2022.01)i; ***B22F 1/05***(2022.01)i; ***B22F 1/10***(2022.01)i; ***C22C 9/00***(2006.01)i; ***C22C 27/04***(2006.01)i; ***C22C 27/06***(2006.01)i; ***C22C 28/00***(2006.01)i; ***H01B 1/00***(2006.01)i; ***H01B 1/02***(2006.01)i; ***H01B 1/22***(2006.01)i; ***H05K 1/03***(2006.01)i; ***H05K 3/12***(2006.01)i

FI: C22C5/06 C; B22F1/00 K; B22F1/00 L; B22F1/00 P; B22F1/00 R; B22F1/05; B22F1/10; C22C9/00; C22C27/04 101; C22C27/06; C22C28/00 B; H01B1/00 L; H01B1/02 Z; H01B1/22 A; H05K1/03 610D; H05K3/12 610B

According to International Patent Classification (IPC) or to both national classification and IPC

**B. FIELDS SEARCHED**

Minimum documentation searched (classification system followed by classification symbols)

C22C5/06; B22F1/00; B22F1/05; B22F1/10; C22C9/00; C22C27/04; C22C27/06; C22C28/00; H01B1/00; H01B1/02; H01B1/22; H05K1/03; H05K3/12

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2007-211348 A (KABUSHIKI KAISHA TOSHIBA) 23 August 2007 (2007-08-23) paragraphs [0017], [0034] | 1-3, 5-10, 12-14, 18-20 |
| Y | | 4, 11, 15-17 |
| Y | JP 2015-218372 A (MITSUBISHI ELECTRIC CORPORATION) 07 December 2015 (2015-12-07) paragraphs [0019]-[0021] | 4 |
| Y | WO 2021/039874 A1 (DAICEL CORP.) 04 March 2021 (2021-03-04) paragraph [0063] | 11, 15-17 |

☐ Further documents are listed in the continuation of Box C.  ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **02 October 2024** | **15 October 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2024/031632**

| Patent document cited in search report | Publication date (day/month/year) | Patent family member(s) | Publication date (day/month/year) |
|---|---|---|---|
| JP 2007-211348 A | 23 August 2007 | (Family: none) | |
| JP 2015-218372 A | 07 December 2015 | (Family: none) | |
| WO 2021/039874 A1 | 04 March 2021 | TW 202126404 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2023146497 A
- WO 2018037992 A